(19) **Europäisches Patentamt**

**European Patent Office**

**Office européen des brevets**

(11) Veröffentlichungsnummer: **0 266 654 B1**

(12) **EUROPÄISCHE PATENTSCHRIFT**

(45) Veröffentlichungstag der Patentschrift: **25.11.92**

(21) Anmeldenummer: **87115716.0**

(22) Anmeldetag: **27.10.87**

(51) Int. Cl.5: **G03F 7/004**

(30) Priorität: **05.11.86 DE 3637717**

(43) Veröffentlichungstag der Anmeldung:
**11.05.88 Patentblatt 88/19**

(45) Bekanntmachung des Hinweises auf die
Patenterteilung:
**25.11.92 Patentblatt 92/48**

(84) Benannte Vertragsstaaten:
**DE FR GB NL**

(56) Entgegenhaltungen:
**EP-A- 0 167 963**

**PATENT ABSTRACTS OF JAPAN, Band 7, Nr.
105 (P-195)[1250], 7. Mai 1983; & JP-A-58 28
739 (NIPPON DENKI K.K.) 19-02-1983**

(73) Patentinhaber: **HOECHST AKTIENGESELL-
SCHAFT
Postfach 80 03 20
W-6230 Frankfurt am Main 80(DE)**

(72) Erfinder: **Stahlhofen, Paul, Dr. Dipl.-Chem.
Leibnizstrasse 18/b
W-6200 Wiesbaden(DE)**

㊴ **Lichtempfindliches Gemisch, dieses enthaltendes Aufzeichnungsmaterial und Verfahren zur
Herstellung von positiven oder negativen Reliefkopien unter Verwendung dieses Materials.**

Anmerkung: Innerhalb von neun Monaten nach der Bekanntmachung des Hinweises auf die Erteilung des
europäischen Patents kann jedermann beim Europäischen Patentamt gegen das erteilte europäische Patent
Einspruch einlegen. Der Einspruch ist schriftlich einzureichen und zu begründen. Er gilt erst als eingelegt, wenn
die Einspruchsgebühr entrichtet worden ist (Art. 99(1) Europäisches Patentübereinkommen).

**Beschreibung**

Die Erfindung betrifft ein lichtempfindliches Gemisch sowie ein daraus hergestelltes Aufzeichnungsmaterial, mit dem wahlweise positive oder negative Reliefkopien einer Vorlage hergestellt werden können.

Es ist bekannt, daß man mittels lichtempfindlicher Materialien auf Basis von Naphthochinondiaziden durch bestimmte Verarbeitungsschritte wahlweise positive oder negative Kopien erhalten kann.

In den DE-A 28 55 723 und 25 29 054 werden Photoresistmaterialien auf Basis von 1,2-Chinondiaziden für ein Umkehrverfahren beschrieben, die als Zusatzstoffe N-Acyl-N′-methyl-ethylendiamine oder Hydroxy-ethylimidazole enthalten. Ein ähnliches Material mit einem Gehalt an sekundären oder tertiären Aminen wird in der US-A 4 196 003 beschrieben. In der EP-A 133 216 wird ein Umkehrverfahren beschrieben, bei dem als Zusatz zur Chinondiazidschicht ein Hexamethylolmelaminether eingesetzt wird, der als thermisches Vernetzungsmittel wirkt.

Alle diese Umkehrverfahren beruhen darauf, daß die Lichtzersetzungsprodukte der 1,2-Chinondiazide beim Erwärmen ein unlösliches Reaktionsprodukt ergeben. Diese thermische Härtung der belichteten 1,2-Chinondiazide erfolgt vorzugsweise in Gegenwart bestimmter basischer oder saurer Zusätze zur lichtempfindlichen Schicht. Sie wird auch durch Zusatz von Vernetzungsmitteln gefördert. Derartige Zusätze haben jedoch im allgemeinen einen nachteiligen Einfluß auf die Lagerfähigkeit der Schichten und auf bestimmte kopiertechnische Eigenschaften, z. B. die Lichtempfindlichkeit und den Bildkontrast nach dem Belichten. Auch ist für viele Anwendungszwecke die zur Bildumkehr erforderliche Temperatur zu hoch oder die Dauer des Erhitzens bei niedrigerer Temperatur zu lang.

Es sind ferner Photoresistgemische vom Positiv- oder Negativtyp bekannt, die neben einem 1,2-Chinondiazid noch negativ arbeitende lichtempfindliche Verbindungen enthalten. In der DE-A 28 10 463 wird ein derartiges lichtempfindliches Aufzeichnungsmaterial beschrieben, dessen lichtempfindliche Komponenten aus einem 1,2-Chinondiazid und einem Nitron bestehen, wobei das verwendete 1,2-Chinondiazid eine höhere UV-Absorption im Wellenlängenbereich von 350 bis 400 nm und eine höhere Absorption im Sichtbaren über 400 nm aufweisen soll als das im Gemisch verwendete Nitron.

Ein ähnlich zusammengesetztes lichtempfindliches Material wird in der DE-A 24 57 895 beschrieben, welches ein 1,2-Chinondiazid im Gemisch mit einer lichthärtbaren Verbindung enthält. Hierbei ist von Nachteil, daß das Verhältnis von lichthärtbarer Substanz zu der 1,2-Chinondiazidverbindung keine großen Toleranzen zuläßt und möglichst exakt eingestellt werden muß, damit aufgrund unterschiedlicher Belichtungszeiten eine Bildumkehr eintritt. Nachteilig ist ferner, daß die Belichtungszeiten, insbesondere für die lichthärtbaren Verbindungen relativ lang sind. Auch ist nach der Positiventwicklung eine längere Nachbelichtung der Bildschablone erforderlich, um diese ausreichend resistent zu machen. Zur Entwicklung der belichteten Schicht werden auch stets unterschiedliche Mengen an organischen Lösungsmitteln zum Entwickler zugesetzt.

Es sind auch andere positiv arbeitende lichtempfindliche Systeme zur wahlweisen Bildumkehr genutzt worden. In der DE-A 31 51 078 ist ein entsprechendes Verfahren mit einem lichtempfindlichen Material beschrieben, das eine Kombination einer säurespaltbaren Verbindung, z. B. eines Polyacetals, mit einer durch Bestrahlung Säure bildenden Verbindung, z. B. einem Trichlormethyl-s-triazin, enthält. Auch hier ist es zur Bildumkehr erforderlich, daß das bildmäßig belichtete Material vor dem Entwickeln einige Zeit auf erhöhte Temperatur erhitzt wird.

Aufgabe der Erfindung war es, ein lichtempfindliches Gemisch vorzuschlagen, das wahlweise zu positiven oder negativen Kopien einer Vorlage verarbeitet werden kan, ohne daß es bei der Verarbeitung erwärmt werden muß, das ohne Zusatz nicht lichtempfindlicher Substanzen zwecks Bildumkehr verarbeitet werden kann und das mit verhältnismäßig kurzen Belichtungszeiten auskommt.

Gegenstand der Erfindung ist ein lichtempfindliches Gemisch, das

a) eine Verbindung mit mindestens einer durch Säure spaltbaren C-O-C-Bindung,

b) eine bei Belichtung eine starke Säure bildende Verbindung und

c) ein in Wasser unlösliches, in wäßrig-alkalischen Lösungen lösliches Bindemittel

enthält.

Das erfindungsgemäße Gemisch ist dadurch gekennzeichnet, daß es ferner

d) eine Verbindung mit mindestens einer polymerisierbaren oder einer lichtvernetzbaren olefinischen Doppelbindung enthält.

Erfindungsgemäß wird weiterhin ein lichtempfindliches Aufzeichnungsmaterial aus einem Schichtträger und einer lichtempfindlichen Schicht vorgeschlagen, die

a) eine Verbindung mit mindestens einer durch Säure spaltbaren C-O-C-Bindung,

b) eine bei Belichtung eine starke Säure bildende Verbindung und

c) ein in Wasser unlösliches, in wäßrig-alkalischen Lösungen lösliches Bindemittel

2

enthält.

Das erfindungsgemäße Aufzeichnungsmaterial ist dadurch gekennzeichnet, daß die lichtempfindliche Schicht ferner

d) eine Verbindung mit mindestens einer polymerisierbaren oder einer lichtvernetzbaren olefinischen Doppelbindung enthält.

Erfindungsgemäß wird ferner ein Verfahren zur Herstellung von positiven Reliefbildern mittels eines Aufzeichnungsmaterials entsprechend der vorstehenden Definition vorgeschlagen, das darin besteht, daß man das Material unter einer Positivvorlage so lange belichtet, bis die belichteten Bereiche der lichtempfindlichen Schicht in einem wäßrig-alkalischen Entwickler löslich, aber noch nicht durch Vernetzung oder Polymerisation der Verbindung (d) unlöslich geworden sind, und danach die belichteten Schichtbereiche mit einem wäßrig-alkalischen Entwickler auswäscht.

Erfindungsgemäß wird schließlich noch ein Verfahren zur Herstellung von negativen Reliefbildern mittels eines Aufzeichnungsmaterials entsprechend der oben gegebenen Definition vorgeschlagen, das darin besteht, daß man das Material unter einer Negativvorlage so lange belichtet, bis die belichteten Bereiche durch Vernetzung oder Polymerisation der Verbindung (d) unlöslich geworden sind, dann die gesamte Schicht ohne Vorlage so lange belichtet, bis die unvernetzten Schichtbereiche in einem wäßrigalkalischen Entwickler löslich, aber noch nicht durch Vernetzung oder Polymerisation der Verbindung (d) unlöslich geworden sind, und dann die löslich gewordenen Schichtbereiche mit einem wäßrig-alkalischen Entwickler auswäscht.

Als lichtempfindliche Komponenten (b), die beim Belichten starke Säuren bilden, sind eine große Anzahl von bekannten Verbindungen und Mischungen, wie Phosphonium-, Sulfonium- und Jodoniumsalze, Halogenverbindungen und Organometall-Organohalogen-Kombinationen geeignet.

Die genannten Phosphonium-, Sulfonium- und Jodoniumverbindungen werden in der Regel eingesetst in Form ihrer in organischen lösungsmitteln löslichen Salze, meist als Abscheidungsprodukt mit komplexen Säuren wie Borfluorwasserstoffsäure, Hexafluorphosphor-, Hexafluorantimon-und -arsensäure.

Grundsätzlich sind als halogenhaltige lichtempfindliche und Halogenwasserstoffsäure bildende Verbindungen alle auch als photochemische Radikalstarter bekannten organischen Halogenverbindungen, beispielsweise solche mit mehr als einem Halogenatom an einem Kohlenstoffatom oder an einem aromatischen Ring, brauchbar. Beispiele sind in den US-A 3 515 552, 3 536 489 und 3 779 778, der DE-C 26 10 842 und den DE-A 22 43 621, 27 18 259 und 33 37 024 beschrieben. Von diesen Verbindungen werden die s-Triazinderivate mit 2 Halogenmethylgruppen, insbesondere Trichlormethylgruppen, und einem aromatischen bzw. ungesättigten Substituenten im Triazinkern, wie sie in den DE-A 27 18 259 und 33 37 024 beschrieben sind, bevorzugt. Ebenso gut geeignet sind die in den DE-A 2 851 471 und 2 949 396 beschriebenen 2-Trichlormethyl-1,3,4-oxadiazole. Die Wirkung dieser halogenhaltigen Verbindungen kann auch durch bekannte Sensibilisatoren spektral beeinflußt und gesteigert werden.

Beispiele für geeignete Starter sind:
4-Methyl-6-trichlormethyl-2-pyron, 4-(3,4,5-Trimethoxystyryl)-6-trichlormethyl-2-pyron, 4-(4-Methoxy-styryl)-6-(3,3,3-trichlor-propenyl)-2-pyron, 2-Trichlormethylbenzimidazol, 2-Tribrommethyl-chinolin, 2,4-Dimethyl-1-tribromacetyl-benzol, 3-Nitro-1-tribromacetyl-benzol, 4-Dibromacetyl-benzoesäure, 1,4-Bis-dibrommethyl-benzol, Tris-dibrommethyl-s-triazin, 2-(6-Methoxy-naphth-2-yl)-, 2-(Naphth-1-yl)-, 2-(Naphth-2-yl)-, 2-(4-Ethoxyethyl-naphth-1-yl)-, 2-(Benzopyran-3-yl)-, 2-(4-Methoxyanthrac-1-yl)-, 2-(4-Styryl-phenyl)-, 2-(Phenanthr-9-yl)-4,6-bis-trichlormethyl-s-triazin und die in den Beispielen angeführten Verbindungen.

Die Menge des Starters kann je nach seiner chemischen Natur under der Zusammensetzung der Schicht ebenfalls sehr verschieden sein. Günstige Ergebnisse werden erhalten mit etwa 0,5 bis 20 Gew.-%, bezogen auf den Gesamtfeststoff, bevorzugt sind 1,0 bis 12 %. Besonders für lichtempfindliche Schichten von Dicken über 0,01 mm empfiehlt es sich, relativ wenig Säurespender zu verwenden.

Als durch Säure spaltbare Verbindungen (a) sind in erster Linie zu nennen:
A) solche mit mindestens einer Orthocarbonsäureester- und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können,
B) Oligomer- oder Polymerverbindungen mit wiederkehrenden Acetal- und/oder Ketalgruppierungen in der Hauptkette und
C) Verbindungen mit mindestens einer Enolether- oder N-Acyliminocarbonatgruppierung.

Durch Säure spaltbare Verbindungen des Typs (A) als Komponenten lichtempfindlicher Gemische sind in der US-A 4 101 323 und in der EP-A 0 022 571 ausführlich beschrieben; Gemische, die Verbindungen des Typs (B) enthalten, sind in den DE-C 23 06 248 und 27 18 254 sowie in der US-A 3 779 778 beschrieben; Verbindungen des Typs (C) werden in den EP-A 0 006 626 und 0 006 627 beschrieben.

Der Anteil der spaltbaren Verbindung kann variiert werden zwischen 4 und 50 Gew.-%, bevorzugt werden 5 bis 30 Gew.-%.

Die lichtempfindliche Schicht enthält ferner ein polymeres, wasserunlösliches Bindemittel (c), das in organischen Lösungsmitteln löslich ist. Da sich als Entwicklerflüssigkeiten für die belichteten Schichten mit Vorteil wäßrig-alkalische Lösungen einsetzen lassen und diese im allgemeinen gegenüber Entwicklern auf Basis organischer Lösungsmittel vorgezogen werden, werden solche Bindemittel verwendet, die in wäßrigen Alkalien löslich oder mindestens quellbar sind.

Die Art und Menge der Bindemittel kann je nach Anwendungszweck verschieden sein; bevorzugt sind Anteile am Gesamtfeststoff zwischen 30 und 90, besonders bevorzugt 50 - 80 Gew.-%.

Die bei vielen Positiv-Kopiermaterialien bewährten Phenolharze, vor allem Novolake, haben sich auch bei den erfindungsgemäßen Materialien als besonders brauchbar und vorteilhaft erwiesen. Sie fördern die starke Differenzierung zwischen den belichteten und unbelichteten Schichtpartien beim Entwickeln, besonders die höher kondensierten Harze mit substituierten Phenolen, z. B. Kresolen, als Formaldehyd-Kondensationspartner. Die Novolake können auch in bekannter Weise durch Umsetzung eines Teils ihrer Hydroxygruppen, z. B. mit Chloressigsäure, Isocyanaten, Epoxiden oder Carbonsäureanhydriden, modifiziert sein. Andere alkalilösliche Harze, wie Mischpolymerisate aus Maleinsäureanhydrid und Styrol, Vinylacetat und Crotonsäure, Methylmethacrylat und Methacrylsäure sind ebenfalls als Bindemittel geeignet.

Zusätzlich können noch zahlreiche andere Harze mitverwendet werden, die entweder wasserlöslich oder aber alkaliunlöslich sein können, bevorzugt Vinylpolymerisate wie Polyvinylacetate, Polyacrylate, Polyvinylether und Polyvinylpyrrolidone, die selbst durch Comonomere modifiziert sein können. Der günstigste Anteil an diesen Harzen richtet sich nach den anwendungstechnischen Erfordernissen und dem Einfluß auf die Entwicklungsbedingungen und beträgt im allgemeinen nicht mehr als 20 % vom alkalilöslichen Harz. In geringen Mengen kann die lichtempfindliche Schicht für spezielle Erfordernisse wie Flexibilität, Haftung, Glanz etc. außerdem noch Substanzen wie Polyglykole, Celluloseether, z. B. Ethylcellulose, Netzmittel, Farbstoffe und feinteilige Pigmente enthalten.

Als polymerisierbare oder lichtvernetzbare Verbindungen (d) werden solche Verbindungen bevorzugt, deren C-C-Doppelbindung in Nachbarschaft zu einer CO-Gruppe steht. Beispiel hierfür sind Verbindungen, die unter dem Namen Chalkone bekannt sind. Auch Bis- oder Tris-Chalkone, Azidochalkone und Derivate der Zimtsäure eignen sich vorzüglich als Photovernetzer im Sinne der Erfindung. Die lichtempfindliche -CH=CH-CO-Gruppe kann sich auch in der Hauptkette oder Seitenkette eines Polymeren befinden, besipielsweise gemäß den US-A 3 030 208, 3 707 373, 3 453 237 oder der DE-A 14 47 016.

Photopolymerisierbare Verbindungen sind Monomere, die mindestens eine, vorzugsweise jedoch zwei oder drei endständige Doppelbindungen im Molekül enthalten, und bei der Bestrahlung mit aktinischem Licht polymerisieren. Derartige Verbindungen sind beschrieben in den US-A 3 261 686 und 3 380 831 und in der GB-A 1 154 872, beispielsweise Acrylsäureester und Methacrylsäureester von Polyolen, wie Diethylenglykoldiacrylat, Diethylenglykoldimethacrylat, Triethylenglykoldiacrylat, Triethylenglykoldimethacrylat, Pentaerythrittriacrylat, Pentaerythrittrimethacrylat, Trimethylolpropantriacrylat, Trimethylolpropantrimethacrylat, Trimethylolethantriacrylat und Trimethylolethantrimethacrylat.

Der Mengenanteil der Verbindungen (d) in der lichtempfindlichen Schicht liegt im allgemeinen zwischen 2 und 30, vorzugsweise zwischen 4 und 20 Gew.-%, bezogen auf die nichtflüchtigen Bestandteile.

Auch das Mengenverhältnis zwischen positiv arbeitender, säurespaltbarer Verbindung (a) und negativ arbeitender, photopolymerisierbarer oder lichtvernetzbarer Verbindung (d) soll in einem bestimmten Bereich liegen, damit in jedem Fall durch kurze Belichtung eine deutliche Photosolubilisierung und durch entsprechend längere Belichtung eine Lichthärtung erreicht wird. Im allgemeinen werden etwa 0,2 bis 5, vorzugsweise etwa 0,3 bis 3 Gewichtsteile der Verbindung (d) je 1 Gewichtsteil der Verbindung (a) eingesetzt. Es hat sich jedoch gezeigt, daß das Mengenverhältnis nicht besonders kritisch ist und daß brauchbare Kombinationen je nach der spezifischen Lichtempfindlichkeit der im einzelnen eingesetzten Bestandteile auch bei Mengenverhältnissen außerhalb der angegebenen Grenzen erhalten werden können.

Im Gegensatz zu den bekannten Gemischen auf Basis von 1,2-Chinondiaziden und photopolymerisierbaren Verbindungen ist bei dem erfindungsgemäßen Gemisch kein zusätzlicher Photoinitiator für die Polymerisation der ungesättigten Verbindung erforderlich. Die Säurespender (b) wirken bei Belichtung zugleich als Radikalbildner und sind daher im Regelfall auch wirksame Photoinitiatoren. Bei Verwendung von lichtvernetzbaren Verbindungen kann es jedoch zweckmäßig sein, die spektrale Empfindlichkeit durch Zusatz von geeigneten Sensibilisatoren in gewünschter Weise zu beeinflussen.

Schließlich können der lichtempfindlichen Schicht noch lösliche oder auch feinteilige dispergierbare Farbstoffe sowie je nach Anwendungszweck auch UV-Absorber zugesetzt werden. Als Farbstoffe haben sich die Triphenylmethanfarbstoffe, insbesondere in der Form ihrer Carbinolbasen, besonders bewährt. Die günstigsten Mengenverhältnisse der Komponenten lassen sich im Einzelfall durch Vorversuche leicht ermitteln.

Die Schichtdicke der lichtempfindlichen Schicht richtet sich im wesentlichen nach dem vorgesehenen Anwendungszweck des Materials. Sie kann im allgemeinen zwischen etwa 500 nm und 0.08 mm, vorzugsweise 0,001 bis 0,05 mm liegen. Für Druckplatten und aus Lösungen aufzubringende Photoresistschichten werden Schichtdicken im Bereich von 0,001 bis 0,01 mm bevorzugt.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone wie Methylethylketon, chlorierte Kohlenwasserstoffe wie Trichlorethylen und 1,1,1-Trichlorethan, Alkohole wie n-Propanol, Ether wie Tetrahydrofuran, Alkoholether wie Ethylenglykolmonoethylether und Ester wie Butylacetat. Es können auch Gemische verwendet werden, die zudem noch für spezielle Zwecke Lösungsmittel wie Acetonitril, Dioxan, Dimethylformamid oder Propylenglykolmethylether enthalten können. Prinzipiell sind alle Lösungsmittel verwendbar, die mit den Schichtkomponenten nicht irreversibel reagieren.

Als Schichtträger für die lichtempfindlichen Gemische eignen sich alle üblicherweise in der Technik in Kopierprozessen eingesetzten Materialien. Als Beispiele seien Kunststofffolien, Isolierplatten mit Kupferauflage, mechanisch oder elektrochemisch aufgerauhtes und ggf. anodisiertes Aluminium, Siebdruckschablonenträger, Holz, Keramik, Glas und Silicium, dessen Oberfläche chemisch z. B. in Siliciumnitrid oder Siliciumdioxid umgewandelt sein kann, genannt.

Bevorzugte Träger für dicke Schichten über 0,01 mm sind Kunststofffolien, die dann als temporäre Träger für Transferschichten dienen. Dafür und für Farbfolien werden Polyesterfolien, z. B. aus Polyethylenterephthalat, bevorzugt. Polyolefinfolien wie Polypropylen sind jedoch ebenfalls geeignet. Als Schichtträger für Schichtdicken unter ca. 0,01 mm werden meist Metalle verwendet. Für Offsetdruckplatten können eingesetzt werden: mechanisch oder chemisch aufgerauhtes und gegebenenfalls anodisiertes Aluminium, das zudem noch chemisch, z. B. mit Polyvinylphosphonsäure, Silikaten oder Phosphaten, vorbehandelt sein kann, außerdem Mehrmetallplatten mit Cu/Cr oder Messing/Cr als oberster Schicht. Für Hochdruckplatten können die erfindungsgemäßen Gemische auf Zink- oder Magnesium-Platten sowie deren handelsübliche mikrokristalline Legierungen aufgetragen werden, außerdem auf ätzbare Kunststoffe wie Polyoxymethylen. Für Tiefdruck-oder Siebdruckformen eignen sich die Gemische durch ihre gute Haftung und Ätzfestigkeit auf Kupfer-bzw. Nickel-Oberflächen. Ebenso lassen sie sich als Photoresist verwenden.

Die Beschichtung kann direkt oder durch Schichtübertragung von temporären Schichtträger erfolgen auf Leiterplatten-Materialien, die aus Isolierplatten mit ein-oder beidseitiger Kupferauflage bestehen, auf Glas oder Keramik-Materialien, die gegebenenfalls haftvermittelnd vorbehandelt sind, und auf Silicium-Scheiben.

Für die Trocknung nach der Beschichtung können die üblichen Geräte und Bedingungen übernommen werden, Temperaturen um 100°C und kurzfristig bis 120° C werden ohne Ein buße an Strahlungsempfindlichkeit vertragen.

Zum Belichten können die üblichen Lichtquellen wie Röhrenlampen, Xenonimpulslampen, metallhalogeniddotierte Quecksilberdampf-Hochdrucklampen und Kohlebogenlampen verwendet werden.

Die bildmäßig belichtete Schicht kann in bekannter Weise mit den für handelsübliche Naphthochinondiazidschichten und Kopierlacke bekannten Entwicklern entfernt werden, und die neuen Materialien können in ihrem Kopierverhalten mit Vorteil auf die bekannten Hilfsmittel wie Entwickler und programmierte Sprühentwicklungsgeräte abgestimmt werden. Die wäßrigen Entwicklerlösungen können z. B. Alkaliphosphate, -silikate, -borate oder -hydroxide und ferner Netzmittel enthalten. Die Wahl des günstigsten Entwicklers kann durch Versuche mit der jeweils verwendeten Schicht ermittelt werden. Bei Bedarf kann die Entwicklung mechanisch unterstützt werden.

Bei der Verarbeitung zur Positivkopie wird das erfindungsgemäße Aufzeichnungsmaterial in bekannter Weise, wie vorstehend beschrieben, unter einer Positivvorlage belichtet, worauf die belichteten Schichtbereiche mit einer wäßrig-alkalischen Entwicklerlösung ausgewaschen werden.

Die Negativverarbeitung verläuft in der Weise, daß das Material unter einer Negativvorlage belichtet wird. Die Belichtungszeit entspricht hier, unter sonst gleichen Bedingungen, etwa dem 3-bis 20-fachen, vorzugsweise dem 4-bis 15-fachen der zur Positivbelichtung erforderlichen Zeit. Längere Belichtungszeiten sind unschädlich, bringen aber keine zusätzliche Verbesserung. Die Schicht wird dann ein zweites Mal, ohne Vorlage so lange belichtet, wie es zur Photosolubilisierung des säurespaltbaren Gemischs erforderlich ist. Hierbei werden die bereits bildmäßig gehärteten Bereiche noch weiter gehärtet; zumeist führt das aber nicht mehr zu einer wesentlichen Änderung im Verhalten bei der Entwicklung. Anschließend werden dan die nachbelichteten, ungehärteten Schichtteile im Entwickler ausgewaschen.

Neben der reinen Positivkopie und der reinen Negativkopie, wie sie vorstehend beschrieben sind, erlauben das erfindungsgemäße Material und Verfahren auch verschiedene vorteilhafte Kombinationen beider Verfahrensweisen. So kann man z. B. nach bildmäßiger Belichtung unter einem Negativ in die unbelichteten Schichtbereiche ein Positivbild einkopieren. Dabei werden alle Schichtteile außer den Bildteilen das Positivbilds belichtet und löslich, ausgenommen die bereits bei der Negativkopie gehärteten Bereiche. Bei der nachfolgenden Entwicklung wird deshalb eine Kombination des Negativbilds mit dem Positivbild erhalten. Diese als "Photocomposing" bekannte Arbeitsweise ist bei der Herstellung von Druckplatten vorteilhaft, die auf einer Druckseite unterschiedliche Bildteile, z. B. Schrift- und Rasterteile, enthalten. Normalerweise werden alle diese Vorlagenteile einer Druckseite auf einen Montagebogen montiert und gleichzeitig auf die Druckplatte kopiert. Bei der hier beschriebenen Arbeitsweise ist es möglich, in sehr einfacher Weise nachträglich weitere Bildteile, z. B. das Rasterbild zu einer bereits aufkopierten Reportage, nachträglich einzukopieren. Hierdurch werden Einsparungen an Zeit und Filmmaterial ermöglicht.

Das erfindungsgemäße lichtempfindliche Material zeichnet sich gegenüber entsprechenden Materialien, deren Positivkomponente ein Naphthochinondiazid ist, z. B. gemäß der DE-A 24 57 895, durch eine wesentlich höhere Lichtempfindlichkeit bei der Positivbelichtung aus. Dadurch wird es möglich, auch entsprechend lichtempfindlichere Negativsysteme bei immer noch ausreichender Differenz zwischen Positiv- und Negativempfindlichkeit einzusetzen.

Bei dem erfindungsgemäßen Verfahren zur Herstellung von Positivkopien ist es nicht erforderlich, nach der Entwicklung des Reliefbilds dieses zwecks Nachhärtung nachzubelichten und dadurch durchgehend zu härten. Es ist überraschend, daß mit dem erfindungsgemäßen Material dieser zusätzliche Verarbeitungsschritt eingespart werden kann, während bei dem aus der DE-A 24 57 895 bekannten Material mit 1,2-Chinondiaziden als Positivkomponente eine derartige Nachbelichtung zur Erzielung einer ausreichenden Resistenz erforderlich ist.

Ein weiterer Vorteil des erfindungsgemäßen Verfahrens ist es, daß die Entwicklung mit rein wäßrigen Lösungen ohne Zusatz organischer Lösungsmittel erfolgen kann. Diese war insofern nicht zur erwarten, als bei der Positivbelichtung stets auch eine Vernetzung oder Polymerisation des Negativsystems in geringerem Maße erfolgen muß, wobei höhermolekulare wasserunlösliche organische Produkte gebildet werden. Das bestätigt die genannte DE-A 24 57 895, in deren Beispielen zur Entwicklung stets Lösungsmittel enthaltende Entwickler eingesetzt werden.

Das erfindungsgemäße Verfahren kann zur Herstellung von Druckformen für den Hoch-, Tief- und Flachdruck sowie von Photoresistschablonen für die subtraktive und additive Leiterplattenherstellung, für die galvanische Herstellung von Nickelrotationszylindern oder für die Maskenherstellung in der Mikroelektronik nach der Lift-off-Technik eingesetzt werden.

Bei der Anwendung als Druckplatten können zur Erhöhung der Widerstandsfähigkeit beim Druck sowie der Resistenz gegen Auswaschmittel, Korrekturmittel und durch UV-Licht härtbare Druckfarben die entwickelten Platten kurze Zeit auf erhöhte Temperaturen erwärmt werden, wie es für Diazoschichten aus der GB-A 1 154 749 bekannt ist.

Im folgenden werden Beispiele für bevorzugte Ausführungsformen des erfindungsgemäßen Aufzeichnungsmaterials angegeben. In den Beispielen stehen Gewichtsteile (Gt) und Volumenteile (Vt) im Verhältnis von g zu ccm. Prozent- und Mengenverhältnisse sind, wenn nichts anderes angegeben ist, in Gewichtseinheiten zu verstehen.

Beispiel 1

Mit einer Lösung von

| | |
|---|---|
| 0,80 Gt | eines Polyacetals aus Triethylenglykol und 2-Ethylbutyraldehyd, |
| 0,40 Gt | 2,4-Bis-trichlormethyl-6-(4-styryl-phenyl)-s-triazin, |
| 6,00 Gt | eines Kresol-Formaldehyd-Novolaks mit einem Erweichungsbereich von 105 - 120 ° C, |
| 0,80 Gt | Trimethylolethantriacrylat und |
| 0,14 Gt | Kristallviolett in |
| 50,00 Gt | Ethylenglykolmonomethylether und |
| 50,00 Gt | Tetrahydrofuran. |

wurde eine elektrochemisch aufgerauhte und anodisierte Aluminiumplatte bechichtet. Der anodisierte Träger war vor dem Auftragen der lichtempfindlichen Kopierschicht mit einer wäßrigen Lösung von 0,1 Gew.-% Polyvinylphosphonsäure behandelt worden.

Das so hergestellte vorsensibilisierte Material mit einem Schichtgewicht von ca. 2 g/m$^2$ wurde durch eine transparente Positiv-Vorlage unter einer 5 kW-Metallhalogenidlampe im Abstand von 110 ccm 15 Sekunden bildmäßig belichtet und anschließend mit einer 4 %igen wäßrigen Natriummetasilikatlösung entwickelt. Durch die Entwicklung wurden die vom Licht getroffenen Anteile der Kopierschicht entfernt, und es blieben die unbelichteten Bildstellen auf dem Schichtträger zurück, wobei man die der Vorlage entsprechende Druckschablone erhielt. Nach dem Einfärben mit fetter Farbe wurde eine druckfertige Positiv-Druckplatte erhalten.

Eine andere Probe des gleichen Materials wurde als Negativ-Druckplatte verarbeitet. Zu diesem Zweck wurde die Probe unter einer Negativ-Vorlage wie oben angegeben 90 Sekunden belichtet und anschließend 15 Sekunden ohne Vorlage ganzflächig nachbelichtet. Beim Entwickeln im gleichen Entwickler wie oben entstand das Umkehrbild der Vorlage.

Eine andere Möglichkeit der Verarbeitung ist das nachträgliche Einkopieren (Photocomposing) von Strich-oder Rastervorlagen auf eine bereits bildmäßig belichtete Druckplatte. Zu diesem Zweck wurde beispielsweise die Druckplatte zunächst unter einer Negativ-Vorlage wie oben angegeben 90 Sekunden bildmäßig belichtet und anschliessend an den noch nicht vom Licht getroffenen Schichtbereichen, die während der ersten Belichtung durch eine Maske abgedeckt waren, unter einem Diapositiv 15 Sekunden belichtet. Die so belichtete Druckplatte wurde ohne weitere Zwischenschritte entwickelt, wobei die bei der Zweitbelichtung belichteten Schichtbereiche mit Ausnahme der bei der Erstbelichtung bereits gehärteten Bereiche im Entwickler gelöst wurden.

In den folgenden Beispielen werden weitere Beschichtungslösungen angegeben, wobei ähnliche Ergebnisse erhalten werden. Wenn nicht gesondert vermerkt, entsprechen Herstellung und Verarbeitung der damit erhaltenen Druckplatten den in Beispiel 1 beschriebenen Bedingungen.

Beispiel 2

Mit einer Lösung von

| | |
|---|---|
| 0,80 Gt | des in Beispiel 1 angegebenen Polyacetals, |
| 0,60 Gt | 2,4-Bis-trichlormethyl-6-(4-ethoxy-naphth-1-yl)-s-triazin, |
| 4,80 Gt | des in Beispiel 1 angegebenen Novolaks, |
| 1,00 Gt | eines Chalkons, hergestellt aus Acetophenon und 4-Methoxybenzaldehyd und |
| 0,07 Gt | Kristallviolett in |
| 50,00 Gt | Ethylenglykolmonomethylether und |
| 60,00 Gt | Tetrahydrofuran |

wurde eine elektrochemisch aufgerauhte und anodisierte Aluminiumplatte beschichtet.

Die Belichtungszeit für die Herstellung einer Positiv-Druckschablone betrug 20 Sekunden, und die zur Herstellung einer Negativ-Druckschablone betrug 100 Sekunden. Als Entwickler wurde eine 7 %ige wäßrige Natriummetasilikatlösung verwendet.

Beispiel 3

Mit einer Lösung von

| | |
|---|---|
| 0,40 Gt | eines Polyorthoesters, hergestellt aus 7,7-Bis-hydroxymethyl-5-oxa-nonanol-(1) und Orthoameisensäuretrimethylester, |
| 0,60 Gt | 2,4-Bis-trichlormethyl-6-[4-(2-ethoxyethoxy)naphth-1-yl]-s-triazin, |
| 4,80 Gt | eines Kresol-Formaldehyd-Butyraldehyd-Novolaks mit einem Erweichungsbereich von 110 - 120° C, |
| 1,00 Gt | Piperonylidenacetophenon und |
| 0,07 Gt | Kristallviolett in |
| 40,00 Gt | Ethylenglykolmonomethylether und |
| 50,00 Gt | Tetrahydrofuran |

wurde eine elektrochemisch aufgerauhte und anodisierte Aluminiumplatte beschichtet, deren Oberfläche mit einer wäßrigen Lösung von Polyvinylphosphonsäure behandelt worden war. Die Belichtungszeit für die Herstellung einer Positiv-Druckform betrug 20 Sekunden, und die zur Herstellung einer Negativ-Druckform betrug 150 Sekunden. Als Entwickler wurde eine 7 %ige wäßrige Natriummetasilikatlösung verwendet.

Beispiel 4

Mit einer Lösung von

| 1,00 Gt | des in Beispiel 1 angegebenen Polyacetals, |
|---|---|
| 0,60 Gt | des in Beispiel 2 angegebenen Triazinderivats, |
| 4,80 Gt | des in Beispiel 1 angegebenen Novolaks, |
| 0,20 Gt | Dicinnamylidenaceton und |
| 0,07 Gt | Kristallviolett in |
| 50,00 Gt | Ethylenglykolmonomethylether und |
| 60,00 Gt | Tetrahydrofuran |

wurde eine elektrochemisch aufgerauhte und anodisierte Aluminiumplatte beschichtet, deren Oberfläche mit einer wäßrigen Lösung von Polyvinylphosphonsäure behandelt worden war. Die Belichtungszeit für die Herstellung einer Positiv-Druckform betrug 40 Sekunden, und die zur Herstellung einer Negativ-Druckform betrug 300 Sekunden. Als Entwickler wurde eine 7 %ige wäßrige Natriummetasilikatlösung verwendet.

Beispiel 5

Mit einer Lösung von

| 0,80 Gt | des in Beispiel 1 angegebenen Polyacetals, |
|---|---|
| 0,40 Gt | des in Beispiel 3 angegebenen Triazinderivats, |
| 6,00 Gt | des in Beispiel 1 angegebenen Novolaks, |
| 0,80 Gt | Trimetylolethantriacrylat und |
| 0,18 Gt | Kristallviolett in |
| 50,00 Gt | Ethylenglykolmonomethylether und |
| 50,00 Gt | Tetrahydrofuran |

wurde eine transparente Polyesterfolie beschichtet.

Die so hergestellte Farbfolie eignet sich vorzüglich zum passergenauen Montieren bei mehrfarbigen Arbeiten. Zur Herstellung einer positiven Montagefolie wurde die lichtempfindliche Farbfolie durch eine transparente Positiv-Vorlage unter einer 5 kW-Metallhalogenidlampe im Abstand von 110 cm 15 Sekunden bildmäßig belichtet und anschließend mit einer 4 %igen wäßrigen Natriummetasilikatlösung entwickelt. Durch die Entwicklung wurden die vom Licht getroffenen Anteile der Kopierschicht entfernt, und es blieben die unbelichteten Bildstellen auf dem Schichtträger zurück, wobei man die der Vorlage entsprechende Farbschablone erhielt.

Zur Herstellung einer negativen Montagefolie wurde eine andere Probe des gleichen Materials unter einer Negativ-Vorlage wie oben angegeben 120 Sekunden belichtet und anschließend 15 Sekunden ohne Vorlage ganzflächig nachbelichtet. Beim Entwickeln im gleichen Entwickler wie oben entstand das Umkehrbild der Vorlage.

**Patentansprüche**

1. Lichtempfindliches Gemisch, das
   a) eine Verbindung mit mindestens einer durch Säure spaltbaren C-O-C-Bindung,
   b) eine bei Belichtung eine starke Säure bildende Verbindung und
   c) ein in Wasser unlösliches, in wäßrig-alkalischen Lösungen lösliches Bindemittel
   enthält, dadurch gekennzeichnet, daß es ferner
   d) eine Verbindung mit mindestens eine polymerisierbaren oder einer lichtvernetzbaren olefinischen Doppelbindung enthält.

2. Lichtempfindliches Gemisch nach Anspruch 1, dadurch gekennzeichnet, daß die polymerisierbare Verbindung (d) ein Ester der Acryl- oder Methacrylsäure ist.

**3.** Lichtempfindliches Gemisch nach Anspruch 1, dadurch gekennzeichnet, daß die lichtvernetzbare Verbindung (d) ein Chalkon oder ein Zimtsäurederivat ist.

**4.** Lichtempfindliches Gemisch nach Anspruch 1, dadurch gekennzeichnet, daß es 0,2 bis 5 Gewichtsteile der Verbindung (d) je Gewichtsteil der Verbindung (a) enthält.

**5.** Lichtempfindliches Gemisch nach Anspruch 1, dadurch gekennzeichnet, daß die bei Belichtung eine starke Säure bildende Verbindung (b) eine heterocyclische Verbindung mit mindestens einer Trihalogenmethylgruppe ist.

**6.** Lichtempfindliches Gemisch nach Anspruch 5, dadurch gekennzeichnet, daß die Verbindung (b) ein durch mindestens eine Trichlormethylgruppe substituiertes s-Triazin ist.

**7.** Lichtempfindliches Gemisch nach Anspruch 1, dadurch gekennzeichnet, daß das Bindemittel (c) ein Novolak ist.

**8.** Lichtempfindliches Aufzeichnungsmaterial aus einem Schichtträger und einer lichtempfindlichen Schicht, die
a) eine Verbindung mit mindestens einer durch Säure spaltbaren C-O-C-Bindung,
b) eine bei Belichtung eine starke Säure bildende Verbindung und
c) ein in Wasser unlösliches, in wäßrig-alkalischen Lösungen lösliches Bindemittel
enthält, dadurch gekennzeichnet, daß sie ferner
d) eine Verbindung mit mindestens einer polymerisierbaren oder einer lichtvernetzbaren olefinischen Doppelbindung ehtält.

**9.** Verfahren zur Herstellung von positiven Reliefbildern mittels wines Aufzeichnungsmaterials gemäß Anspruch 8, dadurch gekennzeichnet, daß man das Material unter einer Positivvorlage so lange belichtet, bis die belichteten Bereiche der lichtempfindlichen Schicht in einem wäßrig-alkalischen Entwickler löslich, aber noch nicht durch Vernetzung oder Polymerisation der Verbindung (d) unlöslich geworden sind, und danach die belichteten Schichtbereiche mit einem wäßrig-alkalischen Entwickler auswäscht.

**10.** Verfahren zur Herstellung von negativen Reliefbildern mittels eines Aufzeichnungsmaterials gemäß Anspruch 8, dadurch gekennzeichnet, daß man das Material unter einer Negativvorlage so lange belichtet, bis die belichteten Bereiche durch Vernetzung oder Polymerisation der Verbindung (d) unlöslich geworden sind, dann die gesamte Schicht ohne Vorlage so lange belichtet, bis die unvernetzten Schichtbereiche in einem wäßrig-alkalischen Entwickler löslich, aber noch nicht durch Vernetzung oder Polymerisation der Verbindung (d) unlöslich geworden sind, und dann die löslich gewordenen Schichtbereiche mit einem wäßrig-alkalischen Entwickler auswäscht.

**Claims**

**1.** A light-sensitive mixture which contains
a) a compound having at least one acid-cleavable C-O-C bond,
b) a compound which forms a strong acid on exposure and
c) a binder which is insoluble in water but soluble in aqueous alkaline solutions,
**characterized in that it further contains**
d) a compound having at least one polymerizable or light-crosslinkable olefinic double bond.

**2.** The light-sensitive mixture as claimed in claim 1, wherein the polymerizable compound (d) is an ester of acrylic or methacrylic acid.

**3.** The light-sensitive mixture as claimed in claim 1, wherein the light-crosslinkable compound (d) is a chalcone or a cinnamic acid derivative.

**4.** The light-sensitive mixture as claimed in claim 1, which contains 0.2 to 5 parts by weight of compound (d) per part by weight of compound (a).

**5.** The light-sensitive mixture as claimed in claim 1, wherein the compound (b) which forms a strong acid on exposure is a heterocyclic compound having having at least one trihalomethyl group.

**6.** The light-sensitive mixture as claimed in claim 5, wherein compound (b) is an s-triazine substituted by at least one trichloromethyl group.

**7.** The light-sensitive mixture as claimed in claim 1, wherein binder (c) is a novolak.

**8.** A light-sensitive recording material comprising a base material and a light-sensitive layer which contains
  a) a compound having at least one acid-cleavable C-O-C bond,
  b) a compound which forms a strong acid on exposure and
  c) a binder which is insoluble in water but soluble in aqueous alkaline solutions,
  **characterized in that it further contains**
  d) a compound having at least one polymerizable or light-crosslinkable olefinic double bond.

**9.** A process for producing positive relief images by means of a recording material as claimed in claim 8, which comprises exposing the material under a positive original until the exposed areas of the light-sensitive layer have become soluble in an aqueous alkaline developer but have not as yet become insoluble through crosslinking or polymerization of compound (d), and then washing out the exposed areas of the layer with an aqueous alkaline developer.

**10.** A process for producing negative relief images by means of a recording material as claimed in claim 8, which comprises exposing the material under a negative original until the exposed areas have become insoluble through crosslinking or polymerization of compound (d), then exposing the entire layer without original until the uncrosslinked areas of the layer have become soluble in an aqueous alkaline developer but have not become insoluble through crosslinking or polymerization of the compound (d), and then washing out the solubilized areas of the layer with an aqueous alkaline developer.

**Revendications**

**1.** Composition photosensible comprenant
  a) un composé comportant au moins une liaison C-O-C clivable par un acide,
  b) un composé générateur d'acide fort par exposition à lumière, et
  c) un liant insoluble dans l'eau et soluble dans les solution alcalines aqueuses,
  caractérisée en ce qu'elle contient en outre
  d) un composé comportant au moins une double liaison oléfinique polymérisable ou photoréticulable.

**2.** Composition photosensible selon la revendication 1, caractérisée en ce que le composé polymérisable (d) est un ester de l'acide acrylique ou méthacrylique.

**3.** Composition photosensible selon la revendication 1, caractérisée en ce que le composé photoréticulable (d) est une chalcone ou un dérivé de l'acide cinnamique.

**4.** Composition photosensible selon la revendication 1, caractérisée en ce qu'elle contient de 0,2 à 5 parties en poids du composé (d) par partie en poids du composé (a).

**5.** Composition photosensible selon la revendication 1, caractérisée en ce que le composé (b) donnant, par exposition à la lumière, un acide fort est un composé hétérocyclique comportant au moins un groupe trihalogénométhyle.

**6.** Composition photosensible selon la revendication 5, caractérisée en ce que le composé (b) est une s-triazine substituée par au moins un groupe trichlorométhyle.

**7.** Composition photosensible selon la revendication 1, caractérisée en ce que le liant (c) est une novolaque.

**8.** Matériau reprographique photosensible comprenant un support de couche et une couche photosensible, qui contient

    a) un composé comportant au moins une liaison C-O-C clivable par un acide,

    b) un composé générateur d'acide fort par exposition à lumière, et

    c) un liant insoluble dans l'eau et soluble dans les solution alcalines aqueuses,

    caractérisée en ce qu'elle contient en outre

    d) un composé comportant au moins une double liaison oléfinique polymérisable ou photoréticulable.

9. Procédé de fabrication d'images positives en relief à l'aide d'un matériau reprographique selon la revendication 8, caractérisé en ce qu'on expose le matériau sous un original positif, aussi longtemps qu'il le faut pour que les zones exposées de la couche photosensible se dissolvent dans un développateur hydro-alcalin mais ne soient pas encore rendues insolubles par réticulation ou polymérisation du composé (d), et on élimine ensuite les zones exposées de la couche par lavage avec un développateur hydro-alcalin.

10. Procédé de fabrication d'images négatives en relief à l'aide d'un matériau reprographique selon la revendication 8, caractérisé en ce qu'on expose le matériau sous un original négatif, aussi longtemps qu'il le faut pour que les zones exposées deviennent insolubles par réticulation ou polymérisation du composé (d), on expose la couche totale, sans original, aussi longtemps qu'il le faut pour que les zones non réticulées de la couche se dissolvent dans un développateur hydro-alcalin mais ne soient pas encore rendues insolubles par réticulation ou polymérisation du composé (d), et on élimine ensuite les zones rendues solubles de la couche, par lavage avec un développateur hydro-alcalin.